Europäisches Patentamt

(19) European Patent Office

Office européen des brevets

(11) **EP 0 900 402 B1**

(12) **EUROPEAN PATENT SPECIFICATION**

(45) Date of publication and mention
of the grant of the patent:
**01.09.2004 Bulletin 2004/36**

(51) Int Cl.⁷: $G02B\ 27/14$, $G03H\ 1/22$, $G11C\ 13/04$, $G11B\ 7/00$, $G03H\ 1/30$

(21) Application number: **96917804.5**

(22) Date of filing: **21.05.1996**

(86) International application number:
**PCT/US1996/005128**

(87) International publication number:
**WO 1997/044697 (27.11.1997 Gazette 1997/51)**

(54) **REFERENCE BEAM AUTO-FOCUS APPARATUS FOR MODULARIZED VOLUME-HOLOGRAPHIC MEMORY**

AUTOFOKUSVORRICHTUNG MIT REFERENZSTRAHL FÜR EINEN MODULAREN VOLUMENHOLOGRAPHISCHEN SPEICHER

APPAREIL AUTO-FOCUS A FAISCEAU DE REFERENCE POUR MEMOIRE MODULAIRE DE VOLUMES HOLOGRAPHIQUES

(84) Designated Contracting States:
**DE FR GB**

(43) Date of publication of application:
**10.03.1999 Bulletin 1999/10**

(73) Proprietor: **Northrop Grumman Corporation Los Angeles, CA 90067-2199 (US)**

(72) Inventors:
• **REIS, James, J.**
  **San Pedro, CA 90732 (US)**
• **DAVIS, Richard, L.**
  **Redando Beach, CA 90277 (US)**

• **STOLL, Howard, M.**
  **Rancho Palos Verdes, CA 90274 (US)**

(74) Representative: **Maury, Richard Philip et al Sommerville & Rushton,
45 Grosvenor Road
St. Albans, Herts AL1 3AW (GB)**

(56) References cited:

| | |
|---|---|
| WO-A-96/32666 | FR-A- 2 254 802 |
| US-A- 3 635 538 | US-A- 3 703 328 |
| US-A- 3 782 802 | US-A- 3 826 556 |
| US-A- 3 987 421 | US-A- 4 076 370 |
| US-A- 4 449 785 | US-A- 5 128 693 |
| US-A- 5 436 867 | US-H- H 738 |

## Description

### Field of the Invention

The present invention relates generally to holographic storage devices and more particularly to a method for addressing holograms stored in a plurality of separate storage media by directing a reference beam to a selected one of the storage medium, focusing the reference beam so as to obtain a substantially flat wavefront within a reference beam plane of the selected storage media, and varying the.angle of the reference beam so as to address a selected hologram stored therein, the selected hologram being read-out as a result of such addressing.

### Background of the Invention

Holographic techniques for storing images are well known. Such techniques are commonly used to store images of three dimensional objects in a wide variety of different applications. Additionally, various methodologies for utilizing such holographic techniques to store digital data for use in computer systems are currently being explored.

The technique for forming holograms comprises splitting the highly coherent output beam of a laser into separate reference and object beams. The reference beam is directed onto the holographic storage medium, e.g., a photorefractive material, while the object beam is directed onto the object whose image is to be stored. Light reflected from the object is directed to the photorefractive material wherein an interference pattern is formed via interference of the reference beam with the reflected light of the object beam. In the case of digital data storage, the object beam may pass through an optical modulator rather than being reflected off the object whose image is to be stored.

Subsequently, directing a reference beam onto the holographic storage medium results in the reconstruction of an image representative of the originally illuminated object or digital data.

Also known are techniques for storing a plurality of such images within a single photorefractive medium via angle-multiplexing of the images. Such angle-multiplexing is discussed in "THEORY OF OPTICAL INFORMATION STORAGE IN SOLIDS," Applied Optics, Vol. 2, No. 4, p. 393 (1963). The method of angle-multiplexing generally involves maintaining a constant angle for the object beam, while varying the angle of the reference beam for each exposure. Angle-multiplexing thus allows a large number of holographic images to be stored within a common volume of photorefractive medium, thereby greatly enhancing the storage density thereof.

In order to provide increased total storage capacity, it is, in general, desirable to utilize multiple holographic storage modules, wherein each storage module comprises a separate storage medium. The use of such multiple storage modules, however, presents technical problems which must be overcome in order to make such construction feasible. One problem commonly associated with the use of multiple storage modules is the ability to quickly and accurately address the desired hologram stored within the storage medium of a selected storage module. Not only must the reference beam be directed to the selected storage medium, but the reference beam must be directed thereto in a manner which provides a sufficiently flat wavefront within the reference beam plane of the selected storage medium to avoid inadvertent, partial recall of other holograms stored within said storage medium.

The degree of flatness required is determined by the angular separation between adjacent multiplexed holograms as discussed in detail below.

As such, it is desirable to provide a means for addressing a plurality of different storage modules and means for adjusting the wavefront flatness of the addressing reference beam, preferably automatically, each time a different storage module is addressed.

### Summary of the Invention

The present invention specifically addresses and alleviates the above-mentioned deficiencies with the prior art. More particularly, the present invention comprises a method for addressing holograms stored in a storage medium, said method comprising the steps of: directing a reference beam to the storage medium; focusing the reference beam so as to obtain a substantially flat wavefront within a reference beam plane of the storage medium; and varying the angle of the reference beam so as to address a selected hologram stored within the storage medium, the selected hologram being read-out as a result of such addressing; as disclosed in US 4,449,785; characterised in that the storage medium is one of a plurality of separate storage media, the separate storage media being spaced apart from one another; the step of directing the reference beam to the storage medium comprises disposing a focusing lens upon a translation stage and moving the translation stage back and forth along an optical axis of the focusing lens; the step of focusing the reference beam comprises adjusting the position of the focusing lens to minimize the flatness tolerance of the storage medium; and the step of varying the angle of the reference beam comprises effecting angular positioning of the reference beam relative to the optical axis of the focusing lens.

Preferably the step of directing the reference beam to the storage medium comprises directing the reference beam to a selected one of the storage media; passing the reference beam through a polarization rotator and directing it incident on a polarizing beam splitter, the combination of the polarization rotator and the polarizing beam splitter defining a switch for directing the reference beam either toward a first storage module or alternatively toward another storage module.

Preferably, the switch is operable to direct the reference beam either toward the first storage module or alternatively on to one or more such polarization rotator/polarizing beam splitter pairs which can similarly be switched so as to direct the reference beam to a desired storage module.

Preferably, the hologram being read-out or reconstructed object beam, is monitored and servo control is utilized so as to effect such focusing of the reference beam via the translation stage.

Optionally, data specifying the position of the translation stage for each different storage medium is stored in a memory. Reading the stored data and moving the translation stage to the indicated position results in at least coarse focusing of the reference beam for that particular storage medium.

The reference beam is preferably directed to a selected one of the plurality of different storage media by aligning the polarization of the reference beam such that the reference beam is reflected by a polarizing beam splitter toward the selected storage medium. The reference beam is otherwise transmitted by the beam splitter, such as when a different storage medium is selected.

These, as well as other advantages of the present invention will be more apparent from the following description and drawings. It is understood that changes in the specific structure shown and described may be made within the scope of the appended claims.

**Brief Description of the Drawings**

> Figure 1 is a schematic representation of a modularized volume-holographic memory comprising a plurality of different storage media as well as the optical system for effecting auto-focus and addressing of selected holograms stored within selected storage media; and
>
> Figure 2 is a schematic representation of a single storage medium showing the formation of beam waists associated with each of the reference beams reflected into the storage media via a cube beam splitter array.

**Detailed Description of the Preferred Embodiment**

The detailed description set forth below in connection with the appended drawings is intended as a description of the presently preferred embodiment of the invention, and is not intended to represent the only form in which the present invention may be constructed or utilized. The description sets forth the functions and sequence of steps for constructing and operating the invention in connection with the illustrated embodiment.

It is to be understood, however, that the same or equivalent functions and sequences may be accomplished by different embodiments that are also intended to be encompassed within the scope of the invention as defined in the appended claims.

The present invention provides a means for generating a well-collimated laser reference beam within any one of N (an integer) holographic storage modules. Together, the N modules comprise a larger holographic memory. Precise and real-time adjustment of reference beam collimation is provided so as to achieve physical interchangability of the N modules.

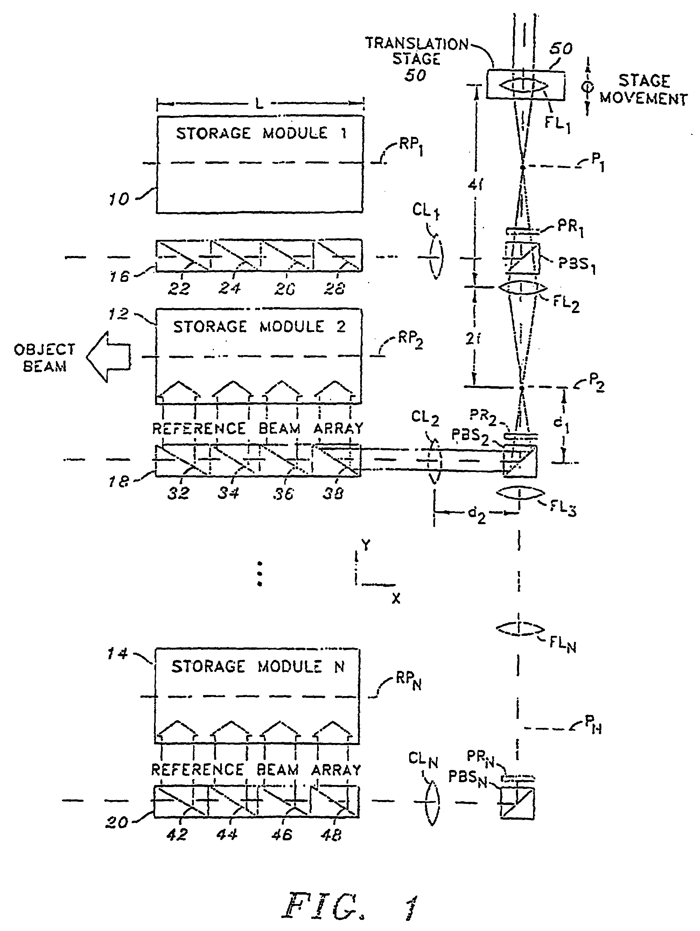

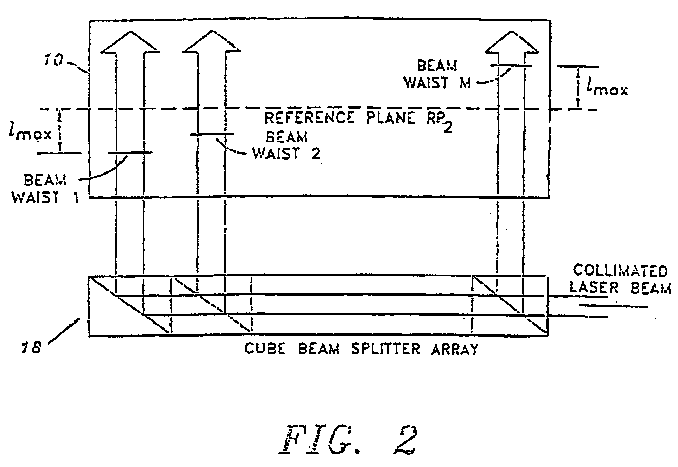

The reference beam auto-focus apparatus for a modularized volume-holographic memory of the present invention is illustrated in Figures 1 and 2, which depict a presently preferred embodiment of the invention.

Referring now to Figure 1, the present invention is comprised generally of a plurality of different storage media or modules such as 10, 12, and 14. As shown, the separate storage media 10, 12, 14 are spaced apart from one another. Reference beam optics direct a reference beam to a selected one of the storage media, focus the reference beam so as to obtain a maximally flat wave front within a reference beam plane of the selected storage medium, and vary the angle of the reference beam so as to address a desired hologram stored therein. Thus, the selected hologram is read-out as a result of such addressing.

More particularly, the focusing lens $FL_1$ is disposed upon translation stage 50 such that movement of translation stage 50 back and forth in the indicated direction, i.e., along the optical axis of focusing lens $FL_1$, effects focusing of the reference beam so as to obtain a substantially flat wave front within a reference beam plane of the selected storage medium.

Means for effecting angular positioning of the reference beam relative to the optical axis of $FL_1$ are preferably disposed prior to $FL_1$ within the optical path of the reference beam, and are not shown. Those skilled in the art will recognize that various such means are suitable for effecting angular positioning of the reference beam. An acousto-optic Bragg cell is one example of such an angular positioning means.

Focusing lens $FL_1$ focuses the collimated laser reference beam, nominally to a point, at $P_1$, from which the reference beam is directed through first polarization rotator $PR_1$. The polarization rotator $PR_1$ may, for example, comprise a liquid crystal material capable of rotating the polarization plane of the reference signal in response to an electrical input.

After passing through the polarization rotator $PR_1$ the reference beam is incident upon polarizing beam splitter $PBS_1$.

The combination of the polarization rotator $PR_1$ and the polarizing beam splitter $PBS_1$ define a switch for directing the reference beam either toward the first storage module 10 or alternatively on to other such polarization rotator/polarizing beam splitter pairs which can similarly be switched so as to direct the reference beam to a desired storage module.

Any hologram within any one of the N holographic storage modules of the memory of Figure 1 can be precisely addressed by translating focusing lens $FL_1$ in the $\pm Y$ direction. Holographic storage module "n" (n = 1, 2, ..., N) is precisely addressed when the reference beam wavefront is flat, to within a certain tolerance to be specified, within reference beam plane $RP_n$ of the selected module. The degree of flatness (in optical wavelengths) is determined by the angular separation between multiplexed holograms. For example, if the length of a module is L, as shown in Figure 1, the optical wave length is $\lambda$, and the angular separation is $\Delta\phi$, then the flatness tolerance is:

$$\Delta f = (L/\lambda)\tan(\Delta\phi).$$

For L = 3 cm, $\Delta\phi = 0.01°$, and $\phi = 488nm$, $\Delta f = 10.7$ optical wavelengths. Given typical optical tolerances, $\Delta f$ is difficult to maintain for reasonably sized memories (N greater than approximately 3), unless provision is made to adjust or minimize $\Delta f$ each time a different storage module is addressed. Focusing lens $FL_1$ performs this adjusting function.

As shown in Figure 1, the second (n = 2) holographic storage module 12 contained within an N-module memory (n = 1, 2, ..., N) has been selected and may be precisely addressed by adjusting the position of focusing lens $FL_1$. As discussed above, the second holographic storage module 12 is selected by adjusting polarization rotator $PR_2$ so as to cause the reference beam to reflect from polarizing beam splitter PBS2 toward the second storage module 12.

Referring now to Figure 2, the combination of spherical lens $CL_2$ and Cube Beam Splitter Array $CBSA_2$ generates "M" reference beam waists within Storage Module 2, where M is the number of elements of $CBSA_2$ (M = 4 in Figure 1). For a given L (length of one of the holographic storage modules) and M, the focal length of $CL_n$ (which is nominally set equal to $d_1 + d_2$ for all n) is selected such that the greatest distance, $l_{MAX}$, between Reference Plane $RP_2$ and Beam Waist "1" or "M" is less than or equal to $\Delta f \cdot \lambda$.

For typical, i.e., economical, optical elements, $\Delta f$ cannot be maintained within tolerance for all storage modules simultaneously, if all elements of the module addressing optics are fixed in position. By attaching Focusing Lens $FL_1$ to a translation stage, however, $\Delta f$ may be minimized in real time in order to address precisely any one of the N modules shown in Figure 1.

Different holograms within a given storage module are individually addressed by adjusting the angle at which the collimated laser beam is incident on $FL_1$. Real-time, closed-loop adjustment of the position of $FL_1$ in the $\pm Y$ direction, is achieved by monitoring a portion of an object beam (Object Beam (2) in the example shown in Figure 1) addressed by the incident reference beam (Reference Beam Array (2) in the example shown in Figure 1). Thus, by maximizing the intensity of a portion of said object beam, $\Delta f$ is minimized by servoing the translation stage upon which $FL_1$ is attached. By this means all holograms within all storage modules may be optimized in real-time.

Coarse minimization of $\Delta f$ for each module may be achieved by pre-storing translation stage positions within a digital memory.

It is understood that the exemplary reference beam auto-focus apparatus for modularized volume-holographic memory shown herein and shown in the drawings represents only a presently preferred embodiment of the present invention. Indeed, various modifications and additions may be made to such embodiment without departing from the scope of the invention as defined in the appended claims. For example, as those skilled in the art will appreciate, various different optical components may be substituted for those illustrated and described. Thus, various lenses, mirrors, etc., may be incorporated, depending upon the particular geometry of the system.

Thus, these and other modifications and additions may be obvious to those skilled in the art and may be adapted for use in a variety of different applications.

## Claims

1. A method for addressing holograms stored in a storage medium (10), said method comprising the steps of:

    a) directing a reference beam to the storage medium (10);
    b) focusing the reference beam so as to obtain a substantially flat wavefront within a reference beam plane of the storage medium (10); and
    c) varying the angle of the reference beam so as to address a selected hologram stored within the storage medium (10), the selected hologram being read-out as a result of such addressing;

    **characterised in that**:

    the storage medium (10) is one of a plurality of separate storage media (10, 12, 14), the separate storage (10, 12, 14) media being spaced apart from one another;
    the step of directing the reference beam to the storage medium (10) comprises disposing a focusing lens ($FL_1$) upon a translation stage (50) and moving the translation stage (50) back and forth along an optical axis of the focusing lens ($FL_1$);
    the step of focusing the reference beam comprises adjusting the position of the focusing lens (FL$_1$) to minimize the flatness tolerance of the storage medium (10); and
the step of varying the angle of the reference beam comprises effecting angular positioning of the reference beam relative to the optical axis of the focusing lens (FL$_1$).

**2.** A method as claimed in Claim 1, wherein the step of directing the reference beam to the storage medium comprises directing the reference beam to a selected one of the storage media; passing the reference beam through a polarization rotator (PR$_1$) and directing it incident on a polarizing beam splitter (PBS$_1$), the combination of the polarization rotator and the polarizing beam splitter defining a switch for directing the reference beam either toward a first storage module (10) or alternatively toward another storage module (12, 14).

**3.** A method as claimed in Claim 2, wherein the switch is operable to direct the reference beam either toward the first storage module (10) or alternatively on to one or more such polarization rotator/polarizing beam splitter pairs (PR$_2$ & PBS$_2$, PR$_N$ & PBS$_N$) which can similarly be switched so as to direct the reference beam to a desired storage module (12, 14).

**4.** A method as claimed in any preceding claim, further comprising the step of monitoring the hologram being read-out and utilizing servo control of the translation stage (50) to effect collimation of the reference beam within the storage medium.

**5.** A method as claimed in any preceding claim, further comprising the steps of:

a) storing data which specifies a position of the translation stage (50) for each storage medium, the position being that which results in at least coarse focusing of the lens for the selected storage medium; and
b) moving the translation stage (50) to the position corresponding to the selected storage medium so as to obtain at least coarse focusing of the reference beam therein.

**6.** A method as claimed in any preceding claim, wherein the step of directing a reference beam to a desired one of a plurality of separate storage media (10, 12, 14) comprises aligning polarization of the reference beam such that the reference beam is reflected by a polarizing beam splitter toward the selected storage medium, the reference beam being transmitted by the beam splitter when a different storage medium is selected.

**Patentansprüche**

**1.** Verfahren zum Adressieren von Hologrammen, die in einem Speichermedium (10) gespeichert sind, wobei das Verfahren die folgenden Schritte umfasst:

a) Richten eines Referenzstrahls auf das Speichermedium (10);
b) Fokussieren des Referenzstrahls, um so eine im wesentlichen flache Wellenfront innerhalb einer Referenzstrahlebene des Speichermediums (10) zu erhalten; und
c) Verändern des Winkels des Referenzstrahles, um so ein gewähltes Hologramm, das innerhalb des Speichermediums (10) gespeichert ist, zu adressieren, wobei das gewählte Hologramm als Folge einer derartigen Adressierung ausgelesen wird;

**dadurch gekennzeichnet, dass**:

das Speichermedium (10) eines einer Vielzahl von getrennten Speichermedien (10, 12, 14) ist, wobei die getrennten Speichermedien (10, 12, 14) voneinander beabstandet angeordnet sind;
der Schritt zum Richten des Referenzstrahls auf das Speichermedium (10) ein Anordnen einer Fokussierungslinse (FL$_1$) auf einem Translationsgestell (50) und ein Bewegen des Translationsgestells (50) hin und her entlang einer optischen Achse der Fokussierungslinse (FL$_1$) umfasst;
der Schritt zum Fokussieren des Referenzstrahls ein Einstellen der Position der Fokussierungslinse (FL$_1$), um die Ebenheitstoleranz des Speichermediums (10) zu minimieren, umfasst; und
der Schritt zum Verändern des Winkels des Referenzstrahls ein Bewirken einer Winkelpositionierung des Referenzstrahls relativ zu der optischen Achse der Fokussierungslinse (FL$_1$) umfasst.

**2.** Verfahren nach Anspruch 1, wobei der Schritt zum Richten des Referenzstrahls auf das Speichermedium ein Richten des Referenzstrahls auf ein gewähltes eines der Speichermedien; ein Führen des Referenzstrahls durch eine Polarisationsdreher (PR$_1$) und ein Richten von diesem einfallend auf einen Polarisationsstrahlteiler (PBS$_1$) umfasst, wobei die Kombination des Polarisationsdrehers und des Polarisationsstrahlteilers einen Schalter zum Richten des Referenzstrahls entweder in Richtung auf ein erstes Speichermodul (10) hin oder alternativ in Richtung auf ein anderes Speichermodul (12, 14) hin definieren.

**3.** Verfahren nach Anspruch 2, wobei der Schalter betreibbar ist, um den Referenzstrahl entweder in Richtung auf das erste Speichermodul (10) hin oder alternativ auf ein oder mehrere derartige Polarisationsdreher/Polarisationsstrahlteiler-Paare (PR$_2$ & PBS$_2$, PR$_N$ & PBS$_N$) zu richten, die in ähnlicher Weise geschaltet werden können, um so den Referenzstrahl auf ein gewünschtes Speichermodul (12, 14) zu richten.

**4.** Verfahren nach irgendeinem vorangehenden Anspruch, ferner umfassend den Schritt zum Überwachen des Hologramms, welches gerade ausgelesen wird, und Verwenden einer Servosteuerung des Translationsgestells (50), um eine Kollimation des Referenzstrahls innerhalb des Speichermediums zu bewirken.

**5.** Verfahren nach irgendeinem vorangehenden Anspruch, ferner umfassend die folgenden Schritte:

a) Speichern von Daten, die eine Position des Translationsgestells (50) für jedes Speichermedium spezifiziert, wobei die Position diejenige ist, die zu wenigstens einer groben Fokussierung der Linse für das gewählte Speichermedium führt; und

b) Bewegen des Translationsgestells (50) an die Position, die dem gewählten Speichermedium entspricht, um so wenigstens eine grobe Fokussierung des Referenzstrahls darin zu erhalten.

**6.** Verfahren nach irgendeinem vorangehenden Anspruch, wobei der Schritt zum Richten eines Referenzstrahls auf ein gewünschtes eines einer Vielzahl von getrennten Speichermedien (10, 12, 14) ein Ausrichten einer Polarisation des Referenzstrahls derart, dass der Referenzstrahl von einem Polarisationsstrahlteiler in Richtung auf das gewählte Speichermedium hin reflektiert wird, wobei der Referenzstrahl durch den Strahlteiler transmittiert wird, wenn ein anderes Speichermedium gewählt wird, umfasst.

**Revendications**

**1.** Procédé pour adresser des hologrammes stockés dans un support de mémoire (10), ledit procédé comprenant les étapes de:

a) direction d'un faisceau de référence sur le support de mémoire (10);
b) focalisation du faisceau de référence afin d'obtenir un front d'onde sensiblement plat dans un plan de faisceau de référence du support de mémoire (10); et
c) action pour faire varier l'angle du faisceau de référence afin d'adresser un hologramme sélectionné qui est stocké dans le support de mémoire (10), l'hologramme sélectionné étant lu en tant que résultat d'un tel adressage,

**caractérisé en ce que**:

le support de mémoire (10) est l'un d'une pluralité de supports de mémoire séparés (10, 12, 14), les supports de mémoire séparés (10, 12, 14) étánt espacés les uns des autres;
l'étape de direction du faisceau de référence sur le support de mémoire (10) comprend la disposition d'une lentille de focalisation (FL$_1$) sur un étage de translation (50) et le déplacement de l'étage de translation (50) en va-et-vient le long d'un axe optique de la lentille de focalisation (FL$_1$);
l'étape de focalisation du faisceau de référence comprend le réglage de la position de la lentille de focalisation (FL$_1$) afin de minimiser la tolérance de planéité du support de mémoire (10); et
l'étape de variation de l'angle du faisceau de référence comprend l'action de positionnement angulaire du faisceau de référence par rapport à l'axe optique de la lentille de focalisation (FL$_1$).

**2.** Procédé selon la revendication 1, dans lequel l'étape pour diriger le faisceau de référence sur le support de mémoire comprend la direction du faisceau de référence sur l'un sélectionné des supports de mémoire; le passage du faisceau de référence au travers d'un moyen de rotation de polarisation (PR$_1$) et sa direction de façon incidente sur un séparateur de faisceau de polarisation (PBS$_1$), la combinaison du moyen de rotation de polarisation et du séparateur de faisceau de polarisation définissant un commutateur pour diriger le faisceau de référence soit vers un premier module de mémoire (10) soit, de façon alternative, vers un autre module de mémoire (12, 14).

**3.** Procédé selon la revendication 2, dans lequel le commutateur peut être actionné pour diriger le faisceau de référence soit vers le premier module de mémoire (10) soit, de façon alternative, sur une ou plusieurs paires qui sont constituées par un moyen de rotation de polarisation/un séparateur de faisceau de polarisation (PR$_2$ & PBS$_2$, PR$_N$ & PBS$_N$) qui peuvent de façon similaire être commutées de façon à diriger le faisceau de référence sur un module de mémoire souhaité (12, 14).

**4.** Procédé selon l'une quelconque des revendications précédentes, comprenant en outre l'étape de surveillance de l'hologramme qui est en train d'être lu et d'utilisation d'une commande asservie de l'étage de translation (50) pour obtenir la collimation du faisceau de référence dans le support de mémoire.

5. Procédé selon l'une quelconque des revendications précédentes, comprenant en outre les étapes de:

> a) stockage de données qui spécifient une position de l'étage de translation (50) pour chaque support de mémoire, la position étant celle qui aboutit à une focalisation la moins grossière de la lentille pour le support de mémoire sélectionné; et
> b) déplacement de l'étage de translation (50) à la position correspondant au support de mémoire sélectionné de façon à obtenir une focalisation la moins grossière du faisceau de référence.

6. Procédé selon l'une quelconque des revendications précédentes, dans lequel l'étape de direction d'un faisceau de référence sur l'un souhaité d'une pluralité de supports de mémoire séparés (10, 12, 14) comprend l'alignement de la polarisation du faisceau de référence de telle sorte que le faisceau de référence soit réfléchi par le séparateur de faisceau de polarisation vers le support de mémoire sélectionné, le faisceau de référence étant transmis par le séparateur de faisceau lorsqu'un support de mémoire différent est sélectionné.

*FIG. 1*

10

BEAM
WAIST M

$l_{max}$

REFERENCE PLANE $RP_2$

$l_{max}$

BEAM
WAIST 2

BEAM
WAIST 1

COLLIMATED
LASER BEAM

18

CUBE BEAM SPLITTER ARRAY

FIG. 2